# EUROPEAN PATENT APPLICATION

(11) **EP 1 691 419 A2**
(43) Date of publication of application: **16.08.2006**
(21) Application number: 06002068.2
(22) Date of filing: 01.02.2006
(51) Int. Cl.: H01L 29/78, H01L 29/41, H01L 21/336

(54) **Field-effect transistor and method of manufacturing a field-effect transistor**

(30) Priority: 10.02.2005 JP 2005035209
(71) Applicant: NEC Electronics Corporation, Kawasaki-shi, Kanagawa 211-8668 (JP)
(72) Inventor: Tsubaki, Shigeki, Nakahara-ku Kawasaki Kanagawa 211-8666 (JP)
(74) Representative: Glawe, Delfs, Moll

(57) **Abstract**

According to the present invention, there is provided a field effect transistor including a source electrode (30) and a drain electrode (29) formed to be spaced apart from each other on a semiconductor substrate (2), a gate electrode (22) disposed between the source electrode (30) and the drain electrode (29), and a field plate electrode (24, 26) disposed via an insulating film (21) above the semiconductor substrate (2) in a region between the gate electrode (22) and the drain electrode (29), wherein a surface of the semiconductor substrate (2) is flat, and a distance between the semiconductor substrate (2) and the field plate electrode (24, 26) increases according as it goes along a direction from the gate electrode (22) towards the drain electrode (29). With this field effect transistor, the breakdown voltage BVdss is ensured; the chronological change in the set current is restrained; and the on-resistance of an amplifying element is reduced.

## Description

This application is based on Japanese Patent application NO. 2005-035209, the content of which is incorporated hereinto by reference.

### BACKGROUND

### Technical Field

The present invention relates to a field effect transistor having a field plate electrode and a method of manufacturing the same.

### Related Art

For W-CDMA (Wideband-Code Division Multiple Access) use, there is an increasing demand for higher performance and downsizing of high-frequency power amplifiers. Since a power supply voltage of 28V is used in base stations, about 80V is needed for a breakdown voltage BVdss between the drain and the source (hereafter simply referred to as "breakdown voltage BVdss") as a performance of amplification elements of a high-frequency power amplifier. Also, since a large power of 280 W or more is required as a high-frequency power output, it is necessary to achieve a higher output per chip by reducing the on-resistance of the amplifying element in realizing the downsizing of high-frequency power amplifiers for base stations. Further, it is important to ensure a long-term reliability. As an amplifying element of this high-frequency power amplifier, development of a field effect transistor such as a lateral MOSFET for high-frequency power amplification (hereafter simply referred to as "lateral power MOSFET") is carried out.

A conventional lateral-type MOSFET raises a problem in that an electric field is concentrated on a neighborhood of the drain-side end of the gate electrode in a diffusion layer. Due to this electric field concentration, hot carriers are generated. By trap of the hot carriers at the gate insulating film or the Si-SiO₂ interface, the drift of the threshold voltage causes. This leads to chronological change in the set current Idq that passes at the time of bias application of the FET, causing an erroneous operation. It is demanded as a target that this chronological change in the set current will be reduced to 5 % or lower in 20 years.

Also, by concentration of the electric field on a neighborhood of the drain-side end of the gate electrode in the diffusion layer, the breakdown voltage BVdss decreases, so that alleviation of the concentration of the electric field is also demanded.

In order to solve these problems, a lateral power MOSFET is being developed having a structure including an N⁻ drain diffusion layer and a field plate electrode (hereafter referred to as FP electrode) disposed thereabove (See, for example, Japanese Laid-open patent publication NOS. 2002-343960, 2004-63922, and H11-261066).

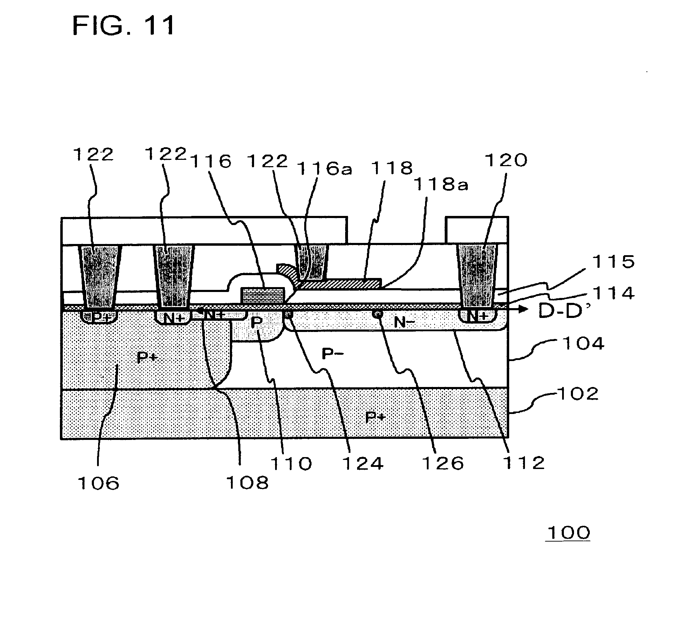

Fig. 11 shows a schematic cross-sectional view of a conventional lateral power MOSFET shown in Japanese Laid-open patent publication NOS. 2002-343960 and 2004-63922. Referring to Fig. 11, the lateral power MOSFET 100 has a P⁻ type epitaxial layer 104 on a P⁺ substrate 102. Also, the lateral power MOSFET 100 has a P⁺ buried diffusion layer 106, an N⁺ source diffusion layer 108, a P channel layer 110, and an N⁻ drain diffusion layer 112 on the P⁺ substrate 102. Also, on the P⁻ type epitaxial layer 104, a drain electrode 120 and a source electrode 122 are connected to predetermined positions, and a gate insulating film 114 is formed. On the gate insulating film 114, a gate electrode 116 is connected. An insulating film 115 is formed above the gate insulating film 114 and the gate electrode 116. A FP electrode 118 is formed on the insulating film 115 in a region between the gate electrode 116 and the drain electrode 120. The FP electrode 118 is located above the N⁻ drain diffusion layer 112, and is connected to the source electrode 122 at the top surface thereof.

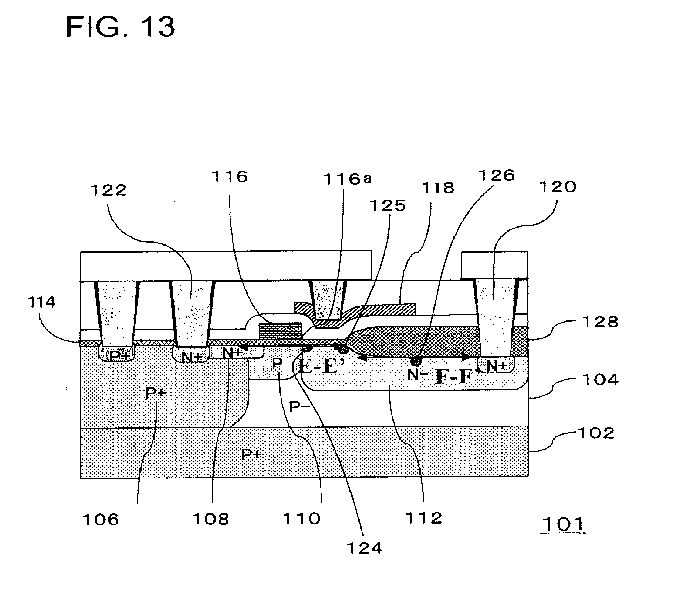

Fig. 13 shows a schematic cross-sectional view of a conventional lateral power MOSFET shown in Japanese Laid-open patent publication NO. H11-261066. In the lateral power MOSFET 101 shown in Fig. 13, a field insulating film 128 is formed on the N⁻ drain diffusion layer 112, unlike the lateral power MOSFET 100 shown in Fig. 11. The field insulating film 128 has a larger film thickness than the gate insulating film 114, and a recess is formed in the surface of the semiconductor substrate. Further, the FP electrode 118 is formed via an insulating film 115 on the field insulating film 128. Since the field insulating film 128 has a hill-like shape that is elevated upwards, the FP electrode 118 has a structure of being tilted upwards on the drain electrode 120 side.

### SUMMARY OF THE INVENTION

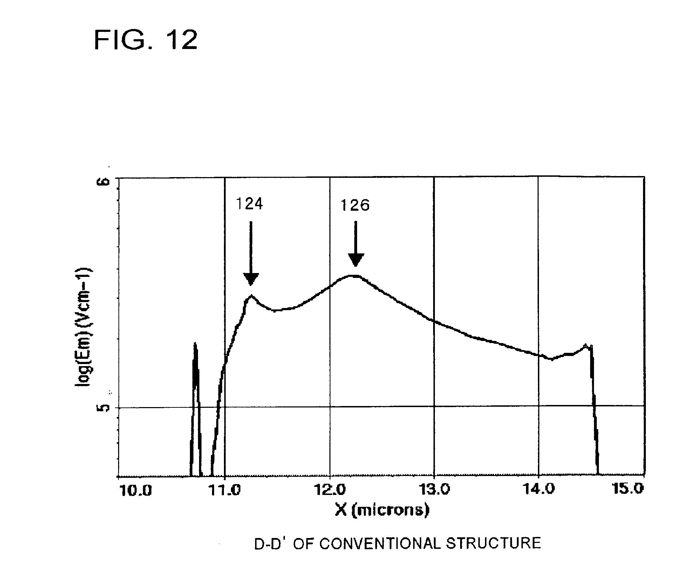

Owing to this structure, the lateral power MOSFET 100 shown in Fig. 11 can restrain the electric field concentration on a region 124 positioned immediately under the gate electrode lower-end 116a at the drain electrode 120 side (hereafter referred to as gate end region) in the N⁻ drain diffusion layer 112. Fig. 12 shows an electric field intensity in the D-D' direction in the lateral power MOSFET 100.

Referring to Fig. 12, the electric field intensity in the drain diffusion layer is dispersed not only in the gate end region 124 but also in the region 126 located immediately under the FP electrode lower-end 118a at the drain electrode 120 side (hereafter referred to as FP end region), so that the electric field concentration on the gate end region 124 is restrained.

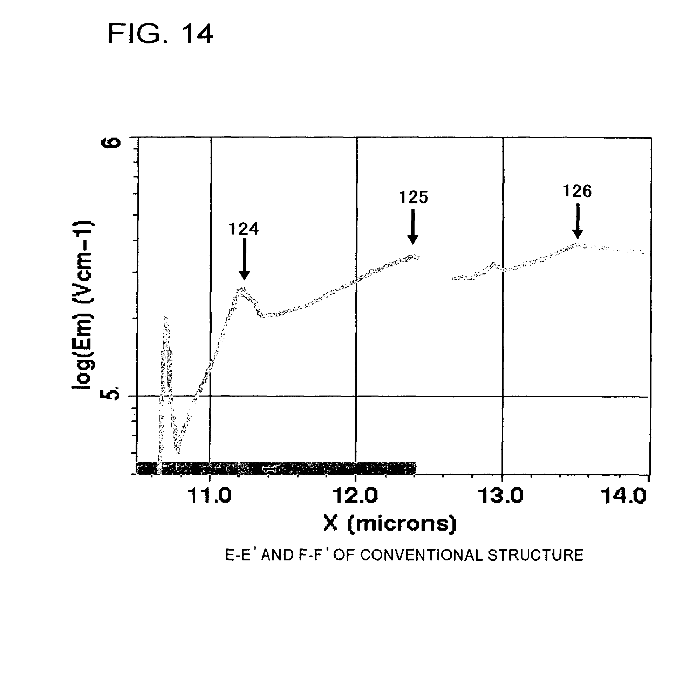

Also, in the lateral power MOSFET 101 shown in Fig. 13, the electric field concentration on the gate end region 124 can be restrained in the N⁻drain diffusion layer 112. Fig. 14 shows electric field intensity in the E-E' direction and in the F-F' direction in the lateral power MOSFET 101.

Referring to Fig. 14, the electric field intensity in the drain diffusion layer is dispersed not only in the gate end region 124 but also in the region 125 located immediately under the field insulating film end (hereafter referred to as field insulating film end region) and in the FP end region 126. For this reason, the electric field concentration on the gate end region 124 is restrained.

In this manner, in both of the lateral power MOSFETs 100, 101, the electric field concentration is alleviated. However, the degree thereof is not sufficient, so that the breakdown voltage BVdss may still decrease sometimes. Also, in order to reduce the on-resistance of the amplifying element, the impurity concentration of the drain diffusionlayer may be raised. Conversely, however, when the impurity concentration in the drain diffusion layer is raised, the breakdown voltage BVdss cannot be ensured, and moreover, the restraint of the chronological change in the set current cannot be achieved.

Therefore, a field effect transistor has been demanded having a field plate electrode with ensured breakdown voltage BVdss, with restrained chronological change in the set current, and with reduced on-resistance of the amplifying element.

According to the present invention, there is provided a field effect transistor including: a source electrode and a drain electrode formed to be spaced apart from each other on a semiconductor substrate; a gate electrode disposed between said source electrode and said drain electrode; and a field plate electrode disposed via an insulating film above said semiconductor substrate in a region between said gate electrode and said drain electrode, wherein a surface of said semiconductor substrate is flat, and a distance between said semiconductor substrate and said field plate electrode increases according as it goes along a direction from said gate electrode towards said drain electrode.

According to this field effect transistor, the breakdown voltage BVdss is ensured; the chronological change in the set current is restrained; andtheon-resistance of the amplifying element is reduced.

In the present invention, the state in which the surface of the semiconductor substrate is "flat" refers to a shape which may include projections and recesses on the surface of the semiconductor substrate within a range that does not impair the effect of the present invention.

According to the present invention, the field plate electrode is disposed so that the distance of the field plate electrode spaced apart from the semiconductor substrate increases according as it goes along a direction from the gate electrode towards the drain electrode. Therefore, a field effect transistor can be provided with reduced on-resistance of the amplifying element, with ensured breakdown voltage BVdss, and with restrained chronological change in the set current. Therefore, the field effect transistor is excellent in the long-term reliability as an amplifying element of a high-frequency power amplifier.

### BRIEF DESCRIPTION OF THE DRAWINGS

The above and other objects, advantages and features of the present invention will be more apparent from the following description taken in conjunction with the accompanying drawings, in which:
Fig. 1 is a schematic cross-sectional view illustrating the first embodiment of a field effect transistor according to the present invention;
Fig. 2 is a graph comparing the electric field intensity in an N⁻ drain diffusion layer;
Fig. 3 is a schematic cross-sectional view illustrating the second embodiment of a field effect transistor according to the present invention;
Fig. 4 is a graph comparing the electric field intensity in an N⁻ drain diffusion layer;
Fig. 5 is a graph comparing the electric field intensity in an N⁻ drain diffusion layer;
Fig. 6 is a schematic cross-sectional view illustrating the third embodiment of a field effect transistor according to the present invention;
Fig. 7 is a graph comparing the electric field intensity in an N- drain diffusion layer;
Fig. 8 is a graph comparing the electric field intensity in an N⁻ drain diffusion layer;
Fig. 9 is a graph comparing the electric field intensity in a lower surface of a FP electrode depending on the difference of the tilt angle.
Figs. 10A to 10D are schematic cross-sectional views illustrating a step of forming a FP electrode;
Fig. 11 is a schematic cross-sectional view illustrating a conventional field effect transistor;
Fig. 12 is a graph illustrating the electric field intensity in an N⁻ drain diffusion layer;
Fig. 13 is a schematic cross-sectional view illustrating a conventional field effect transistor; and
Fig. 14 is a graph illustrating the electric field intensity in an N⁻ drain diffusion layer.

### DETAILED DESCRIPTION

The invention will be now described herein with reference to illustrative embodiments. Those skilled in the art will recognize that many alternative embodiments can be accomplished using the teachings of the present invention and that the invention is not limited to the embodiments illustrated for explanatory purposed.

Hereafter, embodiments of the present invention will be described with reference to the attached drawings. In all of the drawings, similar constituent elements will be denoted with similar symbols, and the explanation thereof will not be described at appropriate times.

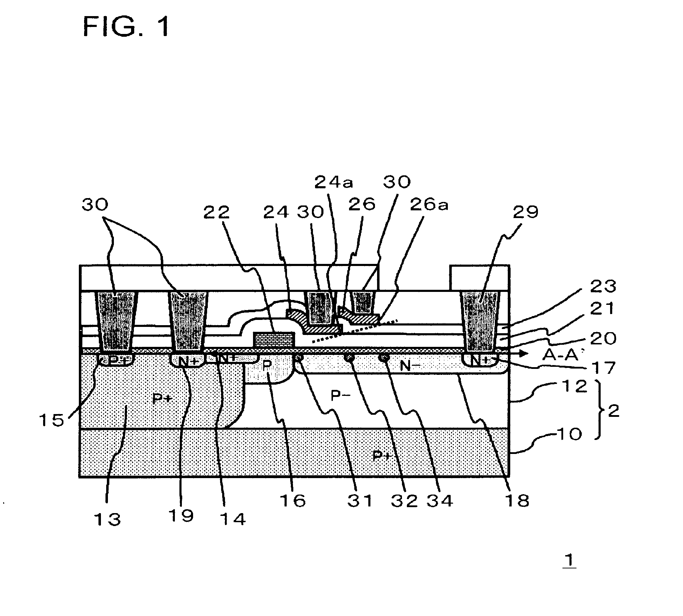

Fig. 1 is a schematic cross-sectional view illustrating the first embodiment of a field effect transistor according to the present invention, namely, a lateral-type MOSFET for high-frequency power amplification (hereafter simply referred to as "lateral power MOSFET").

Referring to Fig. 1, a lateral power MOSFET 1 includes a source electrode 30 and a drain electrode 29 formed to be spaced apart from each other on a semiconductor substrate 2 made of silicon, as well as a gate electrode 22 disposed between the source electrode 30 and the drain electrode 29. In a region between the gate electrode 22 and the drain electrode 29, a first field plate electrode 24 and a second field plate electrode 26 are formed via an insulating film 21 above the semiconductor substrate 2.

The semiconductor substrate 2 is made of a P⁺ substrate 10 and a P-type epitaxial layer 12 formed on the P⁺ substrate 10. A P+ sinker 13, an N⁺ source diffusion layer 14, a P channel diffusion layer 16, and an N⁻ drain diffusion layer 18 are formed on the P⁺ substrate 10. Further, N⁺ contacts 17, 19 and a P⁺ contact 15 are formed in the P⁻ type epitaxial layer 12. The surface of the semiconductor substrate 2 formed in this manner is flat.

The drain electrode 29 is connected onto the N⁺ contact 17, and the source electrode 30 is connected onto the N⁺ contact 19 and the P⁺ contact 15. The source electrode 30 is connected also to a first FP electrode 24 and a second FP electrode 26 that will be described later. A gate insulating film 20 is formed on the semiconductor substrate 2, and a gate electrode 22 is formed thereon. A first insulating film 21 is formed so as to cover the gate insulating film 20 and the gate electrode 22. The first FP electrode 24 is formed on the first insulating film 21. Further, a second insulating film 23 is formed so as to cover the first FP electrode 24 and the first insulating film 21. The second FP electrode 26 is formed on the second insulating film 23. The first FP electrode 24 and the second FP electrode 26 are disposed above the N⁻ drain diffusion layer 18.

The first FP electrode 24 and the second FP electrode 26 are disposed so that the distance thereof from the semiconductor substrate 2 will increase according as it goes along a direction from the gate electrode 22 towards the drain electrode 29. In other words, the first FP electrode 24 and the second FP electrode 26 are disposed so that the line connecting the lower ends 24a, 26a thereof located at the drain electrode side will be tilted upwards according as it goes along a direction towards the drain electrode 29 side, as illustrated in Fig. 1. By disposing the first FP electrode 24 and the second FP electrode 26 at such positions, the concentration of the electric field only on the gate end region 31 in the N⁻ drain diffusion layer 18 can be restrained.

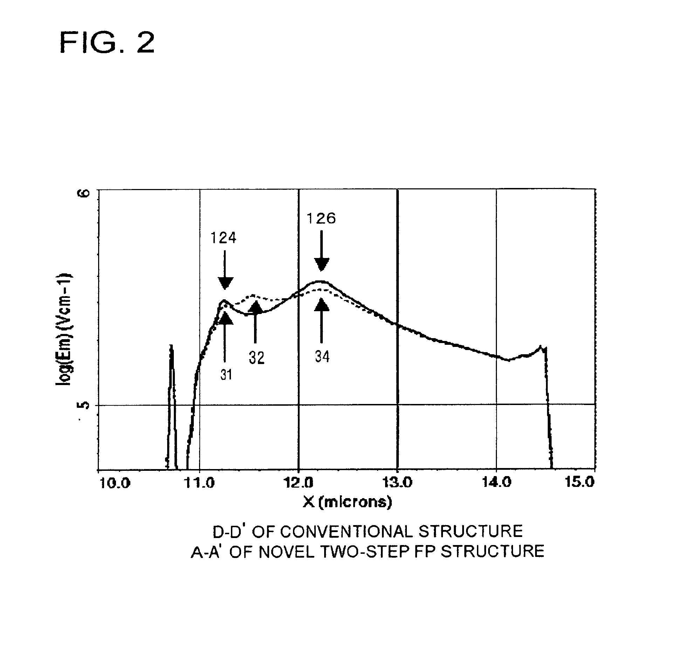

The effects such as shown above will be further described with reference to Fig. 2.

Fig. 2 is a graph showing the electric field intensity in the N⁻ drain diffusion layer 18. The electric field intensity in the A-A' direction of the lateral power MOSFET 1 shown in Fig. 1 and the electric field intensity in the D-D' direction of the lateral power MOSFET 100 shown in Fig. 11 are compared. Here, the impurity concentration in the N⁻ drain diffusion layer remains the same.

Referring to Fig. 2, in the lateral power MOSFET 1 of this embodiment, the electric field intensity in the N⁻ drain diffusion layer 18 is dispersed to the three regions of the gate end region 31, the first FP end region 32, and the second FP end region 34. By such dispersion, the electric field intensity in the gate end region 31 and the second FP end region 34 is reduced as compared with the conventional lateral power MOSFET 100.

Therefore, the lateral power MOSFET 1 of this embodiment produces an effect such that, with the same drain concentration, the chronological change of the set current due to the hot carrier generation is reduced, and the breakdown voltage BVdss is improved. Moreover, since the drain concentration can be raised to attain the same electric field intensity as in the conventional case, the on-resistance can be reduced as compared with the conventional case.

Also, in the lateral power MOSFET 101 described in Fig. 13, it is difficult to form a FP electrode so as to attain a desired electric field intensity as compared with the lateral power MOSFET 1 of the present embodiment. For this reason, the electric field intensity tends to be concentrated on the FP end region 126. This shows that the lateral power MOSFET 1 of the present embodiment produces effects similar to those described above, as compared with the lateral power MOSFET 101.

The lateral power MOSFET 1 can be constructed so that the line connecting the lower end 24a of the first FP electrode 24 and the lower end 26a of the second FP electrode 26 will be tilted for about 5 to 25 degrees, preferably about 10 to 20 degrees, relative to the semiconductor substrate 2. When the tilt angle of the first FP electrode 24 to the second FP electrode 26 is less than 5 degrees, the electric field tends to be concentrated on the second FP end region 34. On the other hand, when the tilt angle exceeds 25 degrees, the electric field tends to be concentrated on the first FP end region 32. In contrast, when the first FP electrode 24 and the second FP electrode 26 are disposed at the above angle, the electric field intensity will be dispersed with a good balance. Therefore, a field effect transistor canbe provided with ensured breakdown voltage BVdss, with restrained chronological change in the set current, and with reduced on-resistance of the amplifying element.

In order to provide a structure in which the first FP electrode 24 and the second FP electrode 26 have such a tilt angle, specifically, the position of forming the first FP electrode 24 and the second FP electrode 26 as well as the film thickness of the first insulating film 21 and the second insulating film 23 are suitably adjusted.

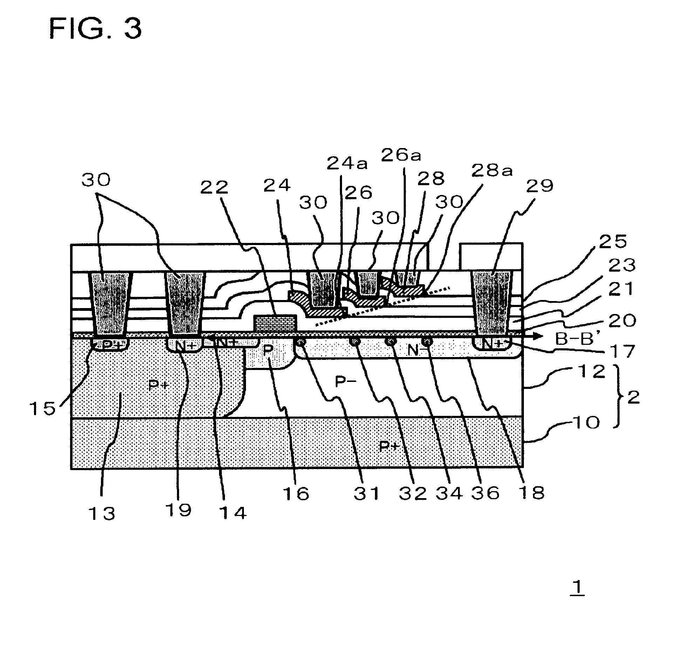

Next, a field effect transistor according to the second embodiment will be described. Fig. 3 shows a schematic cross-sectional view of a field effect transistor according to the second embodiment.

Referring to Fig. 3, the lateral powerMOSFET 1 is further provided with a third FP electrode 28. This third FP electrode 28 is disposed on a third insulating film 25 that is formed so as to cover the second insulating film 23 and the second FP electrode 26. This third FP electrode 28 is electrically connected to the source electrode 30. Here, the surface of the semiconductor substrate 2 is constructed to be flat.

The first FP electrode 24, the second FP electrode 26, and the third FP electrode 28 are disposed so that the distance thereof spaced apart from the semiconductor substrate 2 will increase according as it goes along a direction from the gate electrode 22 towards the drain electrode 29. In other words, the first FP electrode 24, the second FP electrode 26, and the third FP electrode 28 are disposed so that the line connecting the lower ends 24a, 26a, 28a thereof located at the drain electrode side will be tilted upwards according as it goes along a direction towards the drain electrode 29 side, as illustrated in Fig. 3.

By disposing the first FP electrode 24, the second FP electrode 26, and the third FP electrode 28 at such positions, the concentration of the electric field only on the gate end region 31 in the N⁻ drain diffusion layer 18 can be restrained. In other words, as will be described later, in the N⁻ drain diffusion layer 18, the electric field is dispersed because the electric field is concentrated not only on the gate end region 31 but also on the regions (32, 34, 36) located immediately under the lower ends (24a, 26a, 28a) of the first, second, and third FP electrodes.

Therefore, the breakdown voltage BVdss is ensured, and the chronological change in the set current is restrained. Such effects will be particularly prominent when the FP electrodes are disposed so that all the lines connecting the lower ends 24a, 26a, 28a located at the drain electrode side are on one straight line, as shown in Fig. 3, because the electric field intensity to the regions (32, 34, 36) is efficiently dispersed.

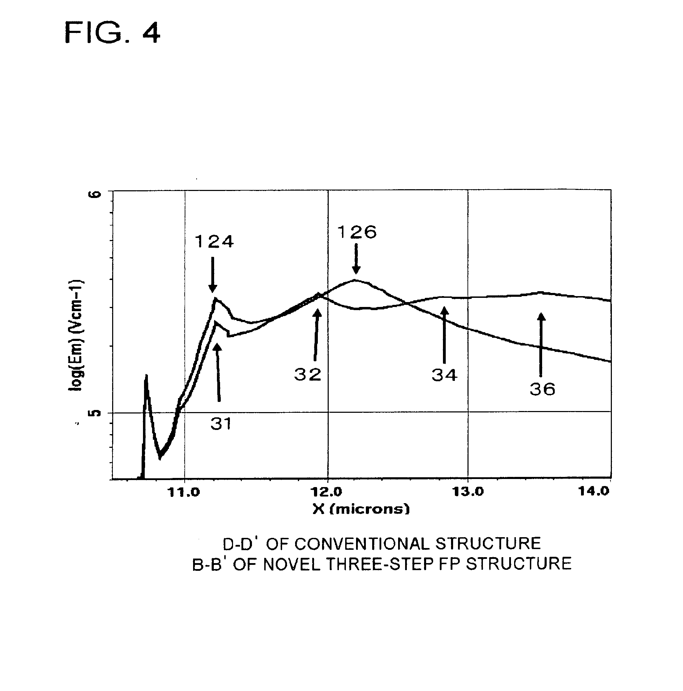

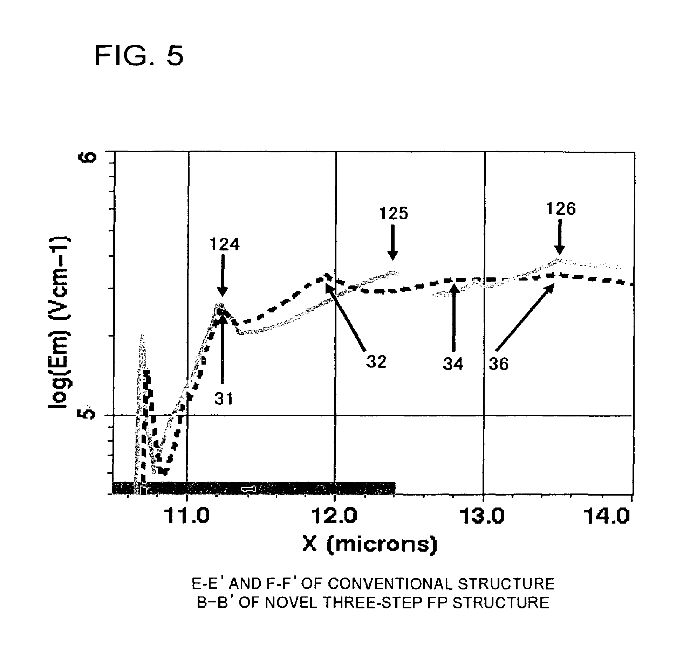

Such effects will be further described with reference to Figs. 4 and 5.

Fig. 4 is a graph showing the electric field intensity in the N⁻ drain diffusion layer 18. The electric field intensity in the B-B' direction of the lateral power MOSFET 1 shown in Fig. 3 and the electric field intensity in the D-D' direction of the lateral power MOSFET 100 shown in Fig. 11 are compared. Here, the impurity concentration in the N⁻ drain diffusion layer remains the same.

Referring to Fig. 4, the electric field intensity in the N⁻ drain diffusion layer 18 is dispersed to the four regions of the gate end region 31, the first FP end region 32, the second FP end region 34, and the third FP end region 36. For this reason, the electric field intensity is reduced as compared with the conventional lateral power MOSFET 100.

On the other hand, in Fig. 5, the electric field intensity in the B-B' direction of the lateral power MOSFET 1 shown in Fig. 3 and the electric field intensity in the E-E' direction and in the F-F' direction of the lateral power MOSFET 101 shown in Fig. 13 are compared. Here, the impurity concentration in the N⁻ draindiffusion layerremains the same.

Referring to Fig. 5, in the conventional lateral power MOSFET 101, peaks of the electric field intensity are present at the field insulating film end region 125 and at the FP end region 126. On the other hand, the electric field intensity of the lateral power MOSFET 1 of the present embodiment is dispersed generally uniformly over the four regions, and the maximum electric field intensity in the lateral power MOSFET 1 is lower than that in the lateral power MOSFET 101. By such dispersion, the electric field intensity is reduced as compared with the conventional lateral power MOSFET 101.

By such dispersion of the electric field intensity, no region receives conspicuous concentration of the electric field intensity as seen in the conventional case. This produces an effect such that the chronological change in the set current due to the hot carrier generation is reduced, and the breakdown voltage BVdss is improved. Moreover, since the drain concentration can be raised to attain the same electric field intensity as in the conventional case, the on-resistance can be reduced as compared with the conventional case.

The lateral power MOSFET 1 can be constructed so that the line connecting the lower end 24a of the first FP electrode 24, the lower end 26a of the second FP electrode 26, and the lower end 28a of the third FP electrode 28 will be tilted for about 5 to 25 degrees, preferably about 10 to 20 degrees, relative to the semiconductor substrate 2.

When the tilt angle of this line is less than 5 degrees, the electric field tends to be concentrated on the third FP end region 36. On the other hand, when the tilt angle exceeds 25 degrees, the electric field tends to be concentrated on the first FP end region 32. In contrast, when the first FP electrode 24, the second FP electrode 26, and the third FP electrode 28 are disposed at the above angle, the electric field intensity will be dispersed with a good balance. Therefore, a field effect transistor can be provided with ensured breakdown voltage BVdss, with restrained chronological change in the set current, and with reduced on-resistance of the amplifying element.

In order to provide a structure in which the first FP electrode 24, the second FP electrode 26, and the third FP electrode 28 have such a tilt angle, a method similar to the above-described method of forming the field effect transistor of the first embodiment can be carried out.

Here, in the first and second embodiments, description has been made by raising examples in which two or three FP electrodes are provided; however, a more number of FP electrodes may be formed within a possible range of design.

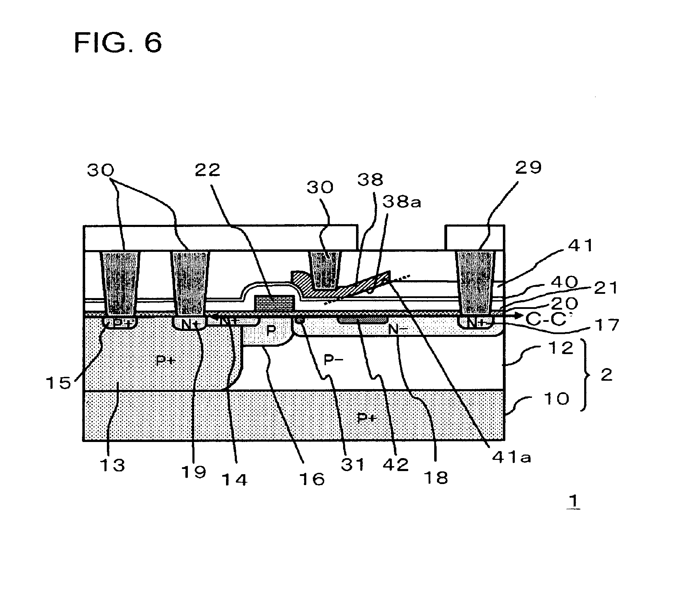

Next, a field effect transistor according to the third embodiment will be described. Fig. 6 shows a schematic cross-sectional view of a field effect transistor according to the third embodiment.

Referring to Fig. 6, in a lateral power MOSFET 1, the surface of a semiconductor substrate 2 is constructed to be flat. A second insulating film 40 made of silicon nitride film or the like is formed on a first insulating film 21 that has been formed to cover a gate electrode 22 and a gate insulating film 20. A third insulating film 41 is formed on the second insulating film 40 at the drain electrode 29 side. The third insulating film 41 has a tilted surface 41a that is tilted upwards according as it goes along a direction from the gate electrode 22 towards the drain electrode 29.

This tilted surface 41a may have a shape with curved parts or with projections and recesses. A FP electrode 38 is formed on the second insulating film 40 and on the tilted surface 41a of the third insulating film 41 in a region between the gate electrode 22 and the drain electrode 29. Therefore, a part of the lower surface 38a of the FP electrode 38 is tilted upwards along a direction towards the drain electrode 29, and is formed to have generally the same angle as the angle of forming the tilted surface 41a. Here, the angle of forming the tilted surface 41a refers to an angle relative to the semiconductor substrate 2. When the tilted surface has curved parts or projections and recesses so as not to be straight, the angle of forming the tilted surface refers to an angle of an average line of the tilted surface to the semiconductor substrate 2. Also, the FP electrode 38 is electrically connected to the source electrode 30. A method of forming the FP electrode 38 such as this will be described later.

The distance between the semiconductor substrate 2 and the lower surface 38a of the FP electrode 38 increases according as it goes along a direction from the gate electrode 22 towards the drain electrode 29. In other words, the lower surface 38a of the FP electrode 38 is tilted upwards according as it goes in a direction towards the drain electrode 29 side, as illustrated in Fig. 6. Because the lower surface 38a of the FP electrode 38 is located at such a position, the concentration of the electric field only on the gate end region 31. in the N⁻ drain diffusion layer 18 can be restrained. Namely, the electric field intensity can be uniformly dispersed, so that the breakdown voltage BVdss is ensured; the chronological change in the set current is restrained; and the field effect transistor will be excellent in long-term reliability.

A conventional lateral power MOSFET also can be recognized to have a mode in which a part of the lower surface of the FP electrode is tilted upwards in a direction towards the drain electrode. However, in a process of designing the conventional lateral power MOSFET, the lower surface of the FP electrode is tilted only accidentally. In contrast to this, in the lateral power MOSFET 1, the FP electrode 38 is formed on the second insulating film 40 and on the tilted surface 41a with adjusted angle in a region between the gate electrode 22 and the drain electrode 29. Therefore, the surface of the FP electrode 38 formed on the second insulating film 40 alleviates the electric field concentration on the gate end region 31, and the whole lower surface 38a of the FP electrode 38 formed on the tilted surface 41a efficiently disperses the electric field concentration. Therefore, the electric field intensity can be uniformly dispersed, so that the breakdown voltage BVdss is ensured; the chronological change in the set current is restrained; and the field effect transistor will be excellent in long-term reliability.

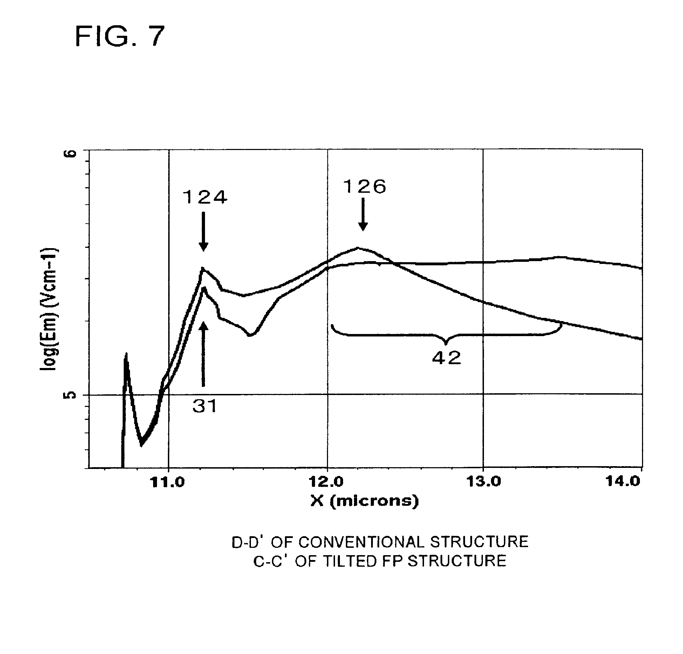

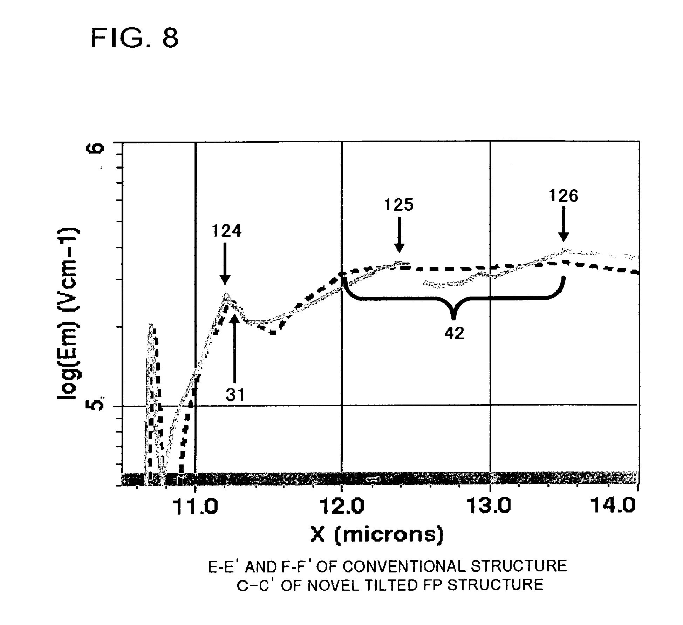

Such effects will be further described with reference to Figs. 7 and 8.

Fig. 7 is a graph showing the electric field intensity in the N⁻ drain diffusion layer 18. The electric field intensity in the C-C' direction of the lateral power MOSFET 1 shown in Fig. 6 and the electric field intensity in the D-D' direction of the lateral power MOSFET 100 shown in Fig. 11 are compared. Here, an example is shown in which the tilt angle of the lower surface 38a of the FP electrode 38 is about 15 degrees. In addition, the impurity concentration in the N⁻ drain diffusion layer remains the same.

Referring to Fig. 7, in the lateral power MOSFET 1 of this embodiment, the electric field intensity in the drain diffusion layer 18 is dispersed to the gate end region 31 and to the region 42 located immediately under the lower surface 38a of the FP electrode 38 and corresponding to the area of the lower surface 38a (hereafter referred to as FP lower-surface region). Because of correspondence to the area of the lower surface 38a, the FP lower-surface region 42 is wide, so that the electric field intensity is further more uniformly dispersed as compared with the conventional structure.

On the other hand, in Fig. 8, the electric field intensity in the C-C' direction of the lateral power MOSFET 1 shown in Fig. 6 and the electric field intensity in the E-E' direction and in the F-F' direction of the lateral powerMOSFET 101 shown in Fig. 13 are compared. Here, the impurityconcentration in the N⁻ drain diffusion layer remains the same.

Referring to Fig. 8, in the conventional lateral power MOSFET 101, peaks of the electric field intensity are present at the field insulating film end 125 and at the FP end 126. On the other hand, the electric field intensity of the lateral power MOSFET 1 of the present embodiment is further uniformly dispersed, and the maximum electric field intensity in the lateral power MOSFET 1 is lower than that in the lateral power MOSFET 101. By such dispersion, the electric field intensity is reduced as compared with the conventional lateral power MOSFET 101.

In the lateral power MOSFET 101 disclosed in Japanese Laid-open patent publication NO. H11-261066 also, the FP electrode 118 is tilted upwards according as it goes along a direction towards the drain electrode 120 side. However, immediately under the FP electrode 118, the surface of the semiconductor substrate is not flat, and a recess is formed, so that it seems to be difficult to control the electric fieldintensity. For this reason, there are cases in which the electric field is concentrated on some ends.

In contrast to this, the lateral power MOSFET 1 of this embodiment produces an effect such that, with the same drain concentration, the chronological change of the set current due to the hot carrier generation is reduced, and the breakdown voltage BVdss is improved. Moreover, since the drain concentration can be raised to attain the same electric field intensity as in the conventional case, the on-resistance can be reduced as compared with the conventional case.

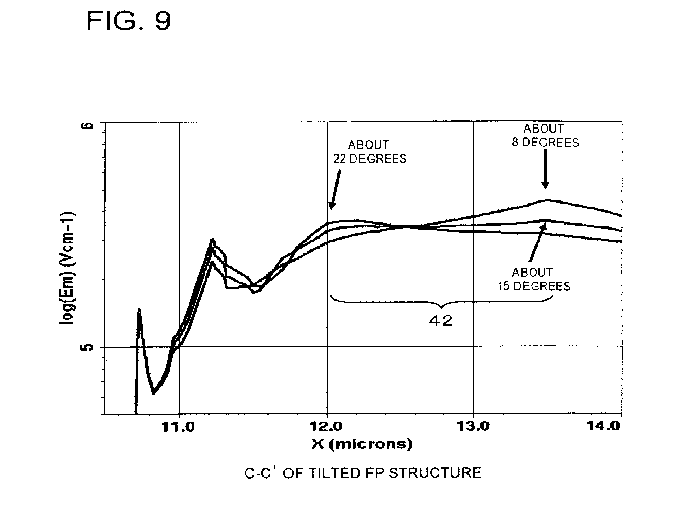

Such an effect will be further described with reference to Fig. 9. Fig. 9 shows examples in which the lower surface 38a of the FP electrode 38 has a tilt angle of about 8 degrees, about 15 degrees, and about 22 degrees. Referring to Fig. 9, when the tilt angle of the lower surface 38a of the FP electrode 38 is small, the electric field in the FP lower-surface region 42 tends to be concentrated in the drain electrode 29 direction. On the other hand, when the tilt angle of the lower surface 38a of the FP electrode 38 is large, the electric field in the FP lower-surface region 42 tends to be concentrated in the gate electrode 22 direction. Therefore, the lower surface 38a of the FP electrode 38 may be set to have a tilt angle of about 5 to 25 degrees, preferably about 10 to 20 degrees.

The FP electrode 38 having a lower surface 38a tilted in this manner can be formed as follows. Here, a method of forming a FP electrode 38 in an upper part of a semiconductor substrate 2 will be described, and explanation of the other parts will not be described at appropriate times.

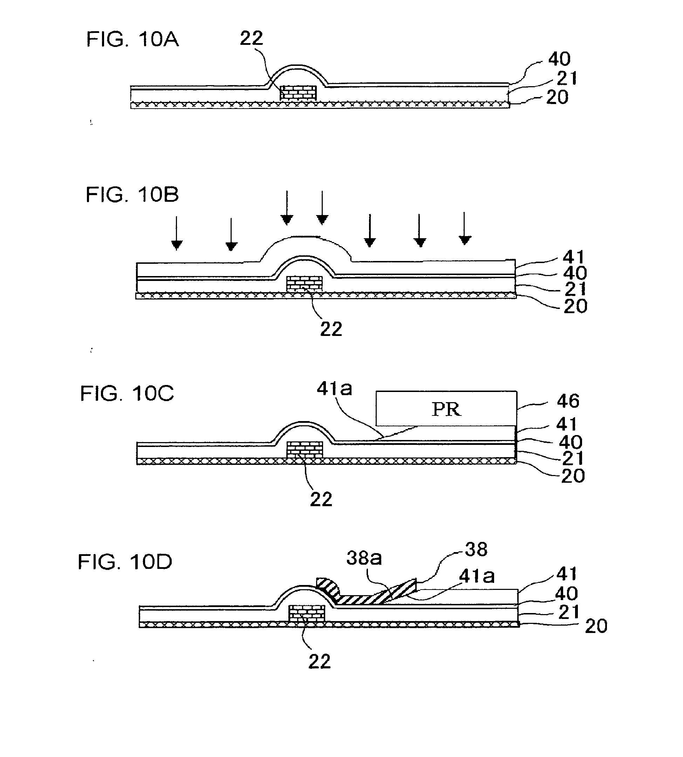

First, referring to Fig. 10A, a gate insulating film 20 is formed on a semiconductor substrate 2, and a gate electrode 22 is formed on the gate insulating film 20. Further, a first insulating film 21 and a second insulating film 40 are successively stacked. The second insulating film 40 is made of a silicon nitride film or the like, and functions as a stopper in an etching step described later.

Subsequently, referring to Fig. 10B, a third insulating film 41 is formed on the second insulating film 40, and ion implantation into the third insulating film 41 is carried out. For this ion implantation, As or the like is used. This enhances the etching rate of the third insulating film 41. Also, the impurities are implanted so that the concentration thereof will decrease in the depth direction of the third insulating film 41. In other words, in the third insulating film 41, the concentration of the impurities is higher to provide a larger etching rate according as it approaches the surface thereof. By providing a concentration gradient in this manner, an angle of forming the tilted surface can be adjusted in an etching step described later. In order to adjust the angle of forming the tilted surface, the energy and the impurity amount of the ion implantation as well as the etching conditions described later are controlled.

Referring to Fig. 10C, a resist film is formed on the third insulating film 41 into which the ion implantation has been carried out, followed by patterning the resist film. This forms a patterned resist film 46 between the gate electrode 22 and the position at which the drain electrode 29 is to be disposed.

Further, through an etching step, the third insulating film 41 located immediately under the resist film 46 is subjected to side etching so as to form a tilted surface 41a in the third insulating film 41. As an etching method, any of the wet etching method and the dry etching method can be used. In the case of wet etching, etching conditions such as the concentration of reagent solution and the period of time can be modified. On the other hand, in the case of dry etching, etching conditions such as the gas composition and the flow rate can be modified. This changes the amount of side etching, and can modify the above-described angle of forming the tilted surface.

Subsequently, after the resist film 46 is removed, a polycrystalline silicon layer or the like is formed, and further a patterning step is carried out so as to form a predetermined shape. By this, a field plate electrode is formed on the second insulating film 40 and on the tilted surface 41a formed in the third insulating film 41, as illustrated in Fig. 10D.

As shown above, the embodiments of the present invention have been described with reference to the attached drawings. However, these only constitute examples of the present invention, so that various modes other than the above can also be adopted.

For example, in the present embodiments, a lateral power MOSFET of N-channel type has been described; however, a lateral power MOSFET of P-channel type can also be described in a similar manner by reversing the electric conductivity type of the impurities. Furthermore, the present invention can be applied to MOSFETs other than lateral power MOSFETs, and can also be applied to a semiconductor substrate other than a silicon substrate.

It is apparent that the present invention is not limited to the above embodiment, that may be modified and changed without departing from the scope and spirit of the invention.

## Claims

1. A field effect transistor comprising:
a source electrode and a drain electrode formed to be spaced apart from each other on a semiconductor substrate;
a gate electrode disposed between said source electrode and said drain electrode; and
a field plate electrode disposed via an insulating film above said semiconductor substrate in a region between said gate electrode and said drain electrode,
wherein a surface of said semiconductor substrate is flat, and a distance between said semiconductor substrate and said field plate electrode increases according as it goes along a direction from said gate electrode towards said drain electrode.

2. The field effect transistor as set forth in claim 1,
wherein said field plate electrode is made of a first field plate electrode and a second field plate electrode that is formed on the first field plate electrode,
said second field plate electrode is formed at said drain electrode side compared to said first field plate electrode towards, and
a distance between said semiconductor substrate and said second field plate electrode is larger than a distance between said semiconductor substrate and said first field plate electrode.

3. The field effect transistor as set forth in claim 2,
wherein said field plate electrode is made of a first field plate electrode formed via a first insulating film on said semiconductor substrate and a second field plate electrode formed via a second insulating film on the first field plate electrode.

4. The field effect transistor as set forth in claim 1,
wherein plural layers of said field plate electrode are stacked via said insulating film, and
a line that connects lower ends located at said drain electrode side of the plural layers of said field plate electrode is tilted upwards according as it goes along a direction towards said drain electrode.

5. The field effect transistor as set forth in claim 4,
wherein all lines connecting the lower ends of the plural layers of said field plate electrode are positioned on one straight line.

6. The field effect transistor as set forth in claim 1,
wherein an other insulating film is formed above said insulating film, said other insulating film having a tilted surface that is tilted upwards according as it goes along a direction from said gate electrode towards said drain electrode, and
said field plate electrode is formed on said insulating film and on said tilted surface.

7. Amethod of manufacturing a field effect transistor, comprising:
stacking a first insulating film and a second insulating film successively above a semiconductor substrate having a gate electrode;
forming a patterned resist film on said second insulating film in a region between said gate electrode and a position where a drain electrode is to be disposed;
forming a tilted surface on said second insulating film, said tilted surface being tilted upwards according as it goes along a direction from said gate electrode towards said drain electrode, by side-etching the second insulating film that is positioned immediately under said resist film, during etching the second insulating by using said patterned resist film as mask; and
forming a field plate electrode on the second insulating film and on said tilted surface in a region between said gate electrode and the position where the drain electrode is to be disposed, by etching after forming a polycrystalline silicon layer on a surface of said first insulating film and said second insulating film.

8. The method of manufacturing a field effect transistor as set forth in claim 7, further comprising performing ion implantation into said second insulating film between said stacking and said forming a patterned resist film.
